# EUROPEAN PATENT APPLICATION

(11) **EP 2 136 444 A1**
(43) Date of publication of application: **23.12.2009**
(21) Application number: 08158718.0
(22) Date of filing: 20.06.2008
(51) Int. Cl.: H01S 5/065, H01S 5/10, H01S 5/125

(54) **Coupled cavity laser diode for generating chaotic signals**

(71) Applicant: Nederlandse Organisatie voor Toegepast- Natuurwetenschappelijk Onderzoek TNO, 2628 VK The Hague (NL)
(72) Inventor: Yousefi, Mirvais, 1013 EN Amsterdam (NL)
(74) Representative: Hatzmann, Martin

(57) **Abstract**

A chaotic light generator device comprises laser structures (10,12) integrated on a common substrate (14). Each laser structure comprises a ridge (100,120) of light amplifying material that forms a waveguide extending between at least partly reflective surfaces (19). Each laser structure (10,12) comprises an injection electrode (102,122) for injecting electric current into the ridge (100,120) of light amplifying material. The laser structures (10,12) are mutually coupled for exchanging light. A current feed circuit (20,22) is coupled to the electrodes (102,122) and configured to apply mutually different current densities to the electrodes of the laser structures (10,12).
Choosing different lengths of the laser structures (10,12) and suitable current densities, chaotic light emission is achieved resulting in ultrashort laser pulses suitable for telecommunication applications.

## Description

### Field of the invention

The invention relates to an optical device for generating chaotic signals, a communication system using such an optical device and to methods for generating chaotic signals and for performing light processing using such chaotic signals.

### Background

Chaotic light generators generate at least partially coherent light with temporally varying properties due to non-linear dynamics that results in chaotic behavior rather than a single stable mode or a simple combination of modes. Chaotic light generators have previously been proposed for example in the context of chaos encryption, optical radar applications, tomography and measurement of optical properties.

Chaotic light generators use non linear dynamics of light bearing media to produce a beam of chaotically varying light. The chaos can either be in the amplitude of the light, in the phase of the light or in both. One type of design of such generators uses a laser source followed by a non-linear modulator and a feedback loop to control modulation dependent on light emerging from the modulator. In these schemes the chaotic signals are based on nonlinearity due to light-matter interaction, with the effect that they are restricted by the relaxation-oscillations resonance and can only generate chaos up to a maximum of 10 GHz bandwidth.

A different approach uses non-linear interaction of light amplifying areas in a laser structure on a chip to generate the chaotic light. Such an approach has been mentioned in an article by Yousefi et al (Physical Review Letters, vol 98, 044101, 2007), titled "Towards a compact laser for chaos encryption". This article uses two front-to-front coupled lasers with mutual injection, in an integrated optical circuit. Ordinarily, such a structure is used as a mode locked laser or a pulsed laser. The lasers each comprise a waveguide of the substantially same length with optically amplifying material in the waveguide between end reflectors and electrodes to inject a common pump current into the optically amplifying material of the lasers. A fraction of laser light generated by each laser is coupled to the other laser. In conventional operation this results in mode locking of the two lasers. However, the article by Yousefi discloses that for lasers of unequal length and certain injection current values chaotic light can be observed when a strong negative bias is applied to a saturable absorber between the two lasers.

The chaotic light generation that is described in this document is based on the principle of optical injection, i.e. interaction of light with light. The integration of the chaos generator on a chip mitigates many of the problems of earlier designs, including sensitivity to environmental noise, increased (> 5 nm) bandwidth of the chaos.

In Yousefi et al ,"Role of longitudinal mode dynamics in laterally coupled lasers", Proc. SPIE, Physics and Simulation of Optoelectronic Devices 4646, nr. 48, pp. 388-396 (2002), the authors analyzed coupled lasers, with emphasis on carrier-light dynamics, and showed that such devices are capable of very complex multi mode operation.

The performance of many applications where chaotic light is used increases with the bandwidth of the chaotic light. Accordingly it is desirable to increase the bandwidth of the chaotic light.

### Summary

Among others, it is an object to provide for chaotic light generators with increased bandwidth.

A device according to claim 1 is provided. Herein a device with first and second, optically coupled laser structures is provided, such as front-to-front coupled lasers, stacked lasers or lasers that run partly side-by-side in a directional coupler structure. An asymmetric selection of the current densities of the laser structures with mutually different values, mode peaks of one laser structure can be caused to overlap with flanking peaks of the other laser structure. This has been found to result in a very wide bandwidth chaotic light.

In an embodiment the device may provide for supply of mutually independently adjustable currents to the laser structures. In this case individual adjustment of the injection currents makes it possible to make the mode peaks of one laser structure overlap with flanking peaks. In another embodiment the geometry of the laser structures is configured so that different current densities result even when equal currents are applied. In this case individual adjustment may be realized by design of the layout of the laser structures.

In an embodiment currents settings are selected that result in a maximum of the bandwidth. A programmable current supply circuit may be used to supply the injection currents to the laser structures.

### Brief description of the drawing

These and other objects and advantageous aspects will become apparent from a description of exemplary embodiments, using the following figures.
- Figure 1a,b: show a laser structure
- Figure 2: shows a supply circuit
- Figure 2a: shows theoretical spectra of individual lasers
- Figure 2b: shows a current map
- Figures 3 and 4: shows laser structures
- Figure 5: shows a light signal processing system

### Detailed description of exemplary embodiments

In following, for the sake of concreteness examples using Indium-Phosphide (InP) technology will be described, which is suitable for the 1.55 µm wavelength regime (the preferred wavelength for fiber based telecommunications). Herein InP is used as an optically amplifying material. However it should be appreciated that it is possible to rescale the devices proposed here and port them to different material families.

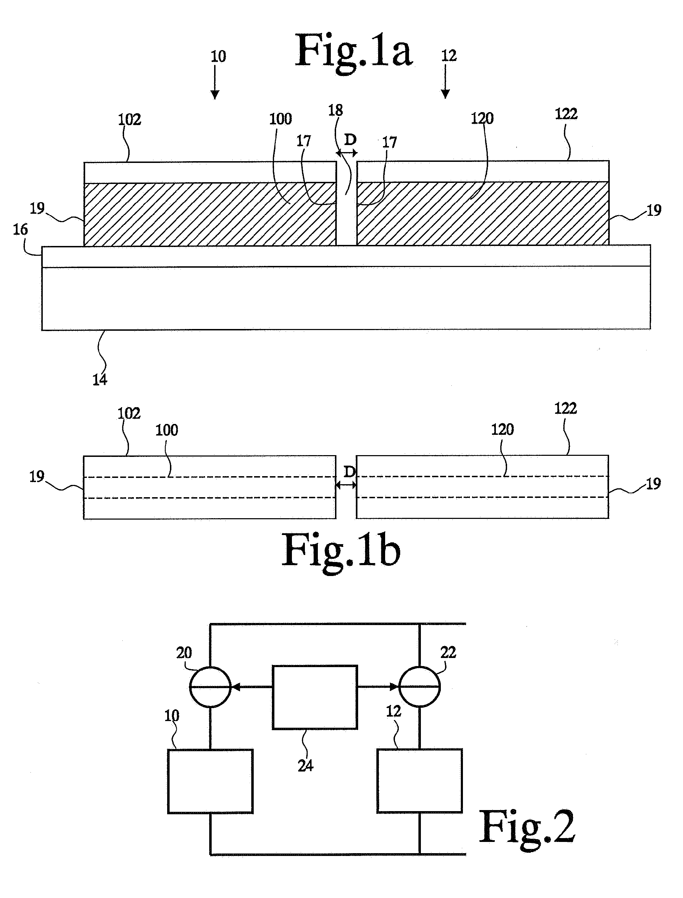

Figures 1a,b schematically illustrate a device comprising two front-to-front coupled multi-longitudinal mode semiconductor laser structures 10, 12, fabricated close together on a chip. Figure 1a shows a lateral view. The device comprises a substrate 14 with a common electrode 16 on top of it. The first laser structure 10 comprises a first ridge 100 of optically active material (InP) vertically between a common electrode 16 and a first electrode 102. Partly reflective surfaces 17, 19 are provided on mutually opposite longitudinal sides of first ridge 100. Similarly, second laser structure 12 comprises a second ridge 120 of optically active material between common electrode 16 and a second electrode 122 vertically and between partly reflective surfaces 17, 19 longitudinally. The dimensions of first and second ridge 100, 120 are selected so that first and second ridge 100, 120 form waveguides for waves traveling between the reflective surfaces.

Figure 1b schematically shows a top view with electrodes 102, 122 covering the ridges 100, 120. Adjacent the ridges and in the intermediate region 18 between the ridges 100, 120 passivator material may be provided.

It should be emphasized that the vertical structure shown in figure 1a is only schematic. Table I illustrates a more detailed example of the vertical structure in a cross-section through ridges 100, 120, in terms of material compositions, thickness and doping concentration of successive layers (herein p and n represent doping polarity and Q stands for quarternary material).

**Table I**

| Layer number | Material | thickness (nM) | doping |
|---|---|---|---|
| 1 | Gold (Au) | 500 | - |
| 2 | Platinum (Pt) | 75 | - |
| 3 | Titatium (Ti) | 65 | - |
| 4 | p- | 200 | 1.5 10¹⁹ |
| 5 | p-InP | 1000 | 1 10¹⁸ |
| 6 | p-InP | 300 | 5 10¹⁷ |
| 7 | p-InP | 200 | 3 10¹⁷ |
| 8 | p-Q | 50 | 1 10¹⁷ |
| 9 | Q | 140 | |
| 10 | Q | 120 | |
| 11 | n-Q | 190 | 6 10¹⁶ |
| 12 | n-InP | 500 | 3.5 10¹⁷ |
| 13 | n-InP | arbitrary | 1-4 10¹⁸ |
| 14 | Titatium (Ti) | 65 | - |
| 15 | Platinum (Pt) | 75 | - |
| 16 | Gold (Au) | 500 | - |

By way of example electrodes 102, 122 comprise layers of Ti, Pt and Au in this example.

Electrodes 102, 122 are electrically isolated from each other. The lengths of the ridges (not shown to scale) between reflective surfaces 17, 19 may be 1 mm for example and their width may be selected below the threshold width for the existence of first order transversal modes. In the illustrated embodiment the length of the two ridges 100, 120 is placed along a common straight line, with partially reflecting surfaces 17 facing each other.

Between these surfaces an intermediate region 18 is present. Intermediate region 18 between the laser structures is obtained by etching through the ridges 100. Subsequently it may be filled with passivator material that is optically, or at least partially transparent, and electrically isolating. A polymer material such as polyamide may be used as passivator material for example. The etched faces of ridges 100, 120 function as partially reflecting surfaces 17, through which light is transmitted from one ridge 100, 120 to another via intermediate region 18. The far ends of the ridges 100, 120 (away from intermediate region 18) may be obtained by cleaving. These cleaved surfaces function as partially reflecting surfaces 19.

Ridges 100, 120 act as waveguides for laser light that reflects partially off reflective surfaces 17, 19. In the illustrated embodiment the two lasers are front-to-front coupled via intermediate region 18. A distance D of approximately 10 µm may be used between laser structures 10, 12, making up the intermediate region 18. The distance is preferably at least as large as half a wavelength in the material of intermediate region 18, and less than ten times this distance.

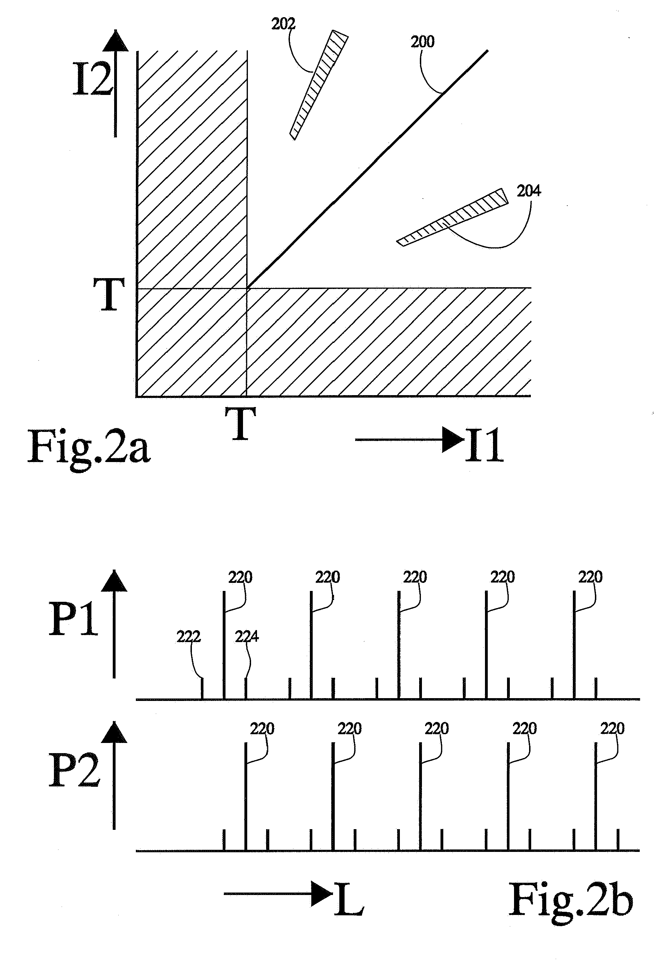

Figure 2 shows an electrical circuit of the chaotic light source. The circuit comprises the laser structures 10, 12, a first and second current source 20, 22, coupled to the first and second electrode 102, 122 of first and second laser structures 10, 12 respectively and a bias current control circuit 24 coupled to control inputs of first and second current source 20, 22. Bias current control circuit 24 is configured to provide for individual control of bias currents supplied to the respective laser structures 10, 12. The bias current control circuit 24 allows for the possibility of asymmetric pumping (i.e. using different currents for the different laser structures) and thus serve as a control mechanism for the chaotic dynamics. Current sources 20, 22 may be implemented using a transistor that has a terminal of a main current channel, such as a drain or collector, coupled to the electrode 102, 122 of the laser structure 10, 12, the current being defined by a voltage supplied to a control electrode of the transistor. Alternatively, a controllable voltage source may be used, coupled to the electrode of the laser structure 10, 12 via a resistive element with a resistance value that is sufficiently high to allow for laser operation.

In general, it suffices to provide for different current densities in ridges 100, 120. When the two structures are identical this can be realized by using different currents, but when the structures are configured to provide for different current densities even when the currents to ridges 100, 120 are the same, the same currents may be used. This may be realized by the layout of the device, for example by using ridges 100, 120 of different width, or electrodes of different width. When different current densities are provided for current sources 20, 22 may be used that are configured to supply identical currents. Using the layout of the optical device to provide for different current densities even if the current are the same has the advantage that parameters that determine the chaotic signal can be hidden in the optical device, to improve secrecy.

The pumping currents co-determine the spectral properties of the laser structures 10, 12. Bias current control circuit 24 sets the currents of the different laser structures in an asymmetric way, in the sense that it avoids coincidence of the main modes of laser structures 10, 12. The setting of the currents will be illustrated using figures 2a,b.

Figure 2a shows a current map, wherein the injection current I1 of first laser structure 10 is plotted horizontally and the injection current I2 of second laser structure 12 is plotted vertically. Each point in the map corresponds to a combination of injection currents. Different points correspond to different behavior of the laser structures. For example, at points in the shaded area at least one of the laser structures is below its threshold for laser operation.

Points above the threshold along the diagonal line 200 correspond to equal currents, where conventional mode locked operation may occur when the laser structures 10, 12 are identical. Most off-diagonal points outside the shaded areas correspond to chaotic light generation. The bandwidth of the chaotic signal has been found to vary dependent on the combination of injection currents used. Special combinations of injection current lead to high bandwidth. By way of example, parts of areas 202, 204 where high bandwidth occur have been indicated by shading (it should be noted that the shape and location of the indicated areas merely serve as illustration and not as a quantitative representation).

Figure 2b illustrates the selection underlying the combinations of injection current leading to high bandwidth. The figure plots parts of theoretical emission power spectra of the laser structures 10, 12 individually, as these spectra would be in the absence of exchange of light between the laser structures 10, 12. The spectra are plotted as a function of wavelength L. As can be seen the spectra contain regularly spaced modal peaks 220, corresponding to standing waves in ridges 100, 120 between reflective surfaces 17, 19. In addition, each peak is flanked by relaxation peaks 222, 224 (only one pair indicated, by way of example) corresponding to the light-matter interaction time scale in the laser ridges 100, 120. The distance between model peaks 220 and relaxation peaks 222, 224 corresponds to the relaxation frequency of the laser structure 10, 12. The square of this relaxation frequency is proportional to the product of the differential gain coefficient of the material in the ridge 100, 120, the photon decay rate in the laser cavity and the average output power in number of photons at the central frequency.

The position of the spectrum can be shifted by varying the injection current because this current affects the index of refraction in the ridge 100, 120. By using different individually controllable injection currents for the different laser structures 10, 12, the spectra of the different laser structures 10, 12 can be shifted relative to each other. High bandwidth chaotic light has been found to occur when a shift is selected that makes the wavelength of modal peaks 220 of one laser structure 10, 12 coincide with relaxation peaks 222, 224 of the other laser structure. The areas 202, 204 of current combinations with high bandwidth of figure 2a correspond to current settings that provide for such coincident peaks.

Although flanking relaxation peaks are used, the mechanism that underlies the peaks is not important for the wide bandwidth. Any type of flanking peaks may be used that are not node peaks. As user herein, modal peaks are peaks that occur at regular distances corresponding to respective standing wave patterns in a laser structure 10, 12 and flanking peaks are any peaks adjacent to modal peaks at a distance to the adjacent modal peak that does not correspond to the regular distance due to respective standing wave patterns.

Nor is exact coincidence between the peaks necessary for high bandwidth. The peaks of the spectra have a finite width, so that overlap occurs even if the central wavelengths of the peaks do not coincide. An overlap of at least twenty percent may be effective to produce high bandwidth chaotic signals. Overlap of peaks may be defined as an integral of normalized peak intensity of the peak of one laser structure 10, 12 over wavelength or frequency, weighted by normalized peak intensity of the peak of the other laser structure 10, 12.

Bias current control circuit 24 is configured to set the injection currents provided by current sources 20, 22 to a combination of injection currents that makes the modal peaks 220 of the individual spectrum of one laser structure 10, 12 effectively overlap flanking peaks 224, of the individual spectrum of the other laser structure 10, 12. Such a setting will be called "asymmetrical", which term is defined by the fact that coincidence of the modal peaks 220 of the different laser structures 10, 12 is avoided.

When there is manufacturing spread between different devices, the required current settings may need to be selected experimentally after manufacture of each device. The location of the modal peaks and the flanking peaks depends on a number of factors that may vary from device to device, such as the sizes of the structures in the manufactured device, material properties in the device etc. After manufacture, the resulting individual spectra of the respective laser structures 10, 12 may be measured and current settings may be selected that result in the desired overlap of modal peaks and flanking peaks. A programmable current control circuit 24 may used, in which the selected current settings may be programmed into current control circuit 24. Programming may be supported by providing for a non-volatile memory in programmable current control circuit 24, to store control values for the current, or programmable fuses etc. Programmable current control circuit 24 may comprise a digital to analog conversion circuit to control the current dependent on the programmed value.

When the currents are selected, it may not be needed to observe the location of the peaks 220, 222, 224. Instead the spectrum of the chaotic light may be observed and the combination of currents may be varied to identify a combination that results in maximum bandwidth. In an embodiment the maximum is selected among current combinations wherein the sum of the currents to the electrodes 102, 122 of the laser structures is constant, i.e. along a diagonal line slanting downward in the map of figure 1a. The sum may be varied in order to optimize power output. Instead the maximum may be selected along any other curve that crosses the mode lock line 200, or in a two-dimensional area. When very accurate manufacturing techniques are used, the currents may even be preset at manufacture, without measuring properties of the devices. It may be noted that the selected currents of the first and second laser structure 10, 12 that result in high bandwidth will generally be different from each other, even if first and second laser structure 10, 12 are structurally identical or substantially identical.

In operation the addition of extra light into laser structure 12 from the other laser structure 10 via intermediate region 18 will change the state of the standing wave in laser 12 and alter this balance. If the change of the carrier density is sufficiently strong this forces laser 12 to change its state, i.e. so switch to a different mode pattern. In return the light from this new state of laser 12 will now be injected into laser 10, which in-turn will be forced to change its state. In this manner, the two lasers will mutually influence each other and force each other to dynamics, which can range from regular oscillations to very complex chaotic dynamics, depending on the injection strength between the two lasers.

The injected light will force the laser to change its state, thus exciting the relaxation oscillations. These excited relaxation oscillations will generate new dynamics in the (spectral) vicinity of each longitudinal mode at the relaxation oscillations frequency and since normally of the order of 100 modes are active simultaneously, the whole frequency spectrum can be filled with light, to produce a flat spectrum. Unlike earlier devices, the geometry will generate chaotic dynamics over the whole gain bandwidth of the material.

Chaotic behavior is promoted because each laser 10, 12 operates on multiple longitudinal modes. Preferably, restrictions on the number of modes are avoided. Thus for example optically passive material, instead of a more conventional saturating absorber is used in the intermediate region between the laser structures 10, 12. Each laser therefore emits a broad band spectrum that is restricted by the material gain bandwidth and which is results in a spectrum with laser longitudinal mode lines. The optical path length of the laser structures 10, 12 is preferably chosen such that the free spectral range (FSR) of the laser is approximately equal to twice the relaxation oscillations frequency.

To avoid uncontrollable nonlinear dynamics, the two lasers are preferably electrically isolated from each other, so that no electronic coupling exists and the optical coupling is the only source of the nonlinear dynamics. This may be realized by etching through the entire ridge 100, 120 when intermediate region 18 is defined and by using electrically isolating material in that region.

In alternative embodiments the laser structures may be located with their lengths side by side to achieve lateral coupling or even fabricated in a vertical configuration. Manufacture of vertical configurations is described for example in an article by Studenkov, P.V. Gokhale, M.R. Forrest, S.R. " Efficient coupling in integrated twin-waveguide lasers using waveguide tapers", IEEE Photonics Technology letters, vol 11, pp. 1096-1098 (1999)). In contrast to the vertical integration suggested by Studenkov et al, in the present device case both ridges layers would be active and both would have an independent current contact.

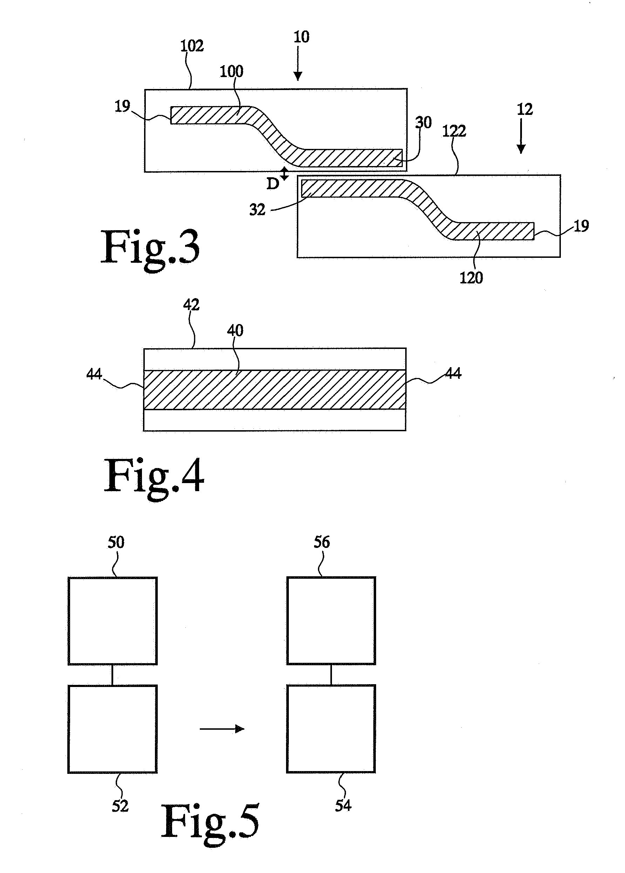

Figure 3 shows an alternative structure with side-by-side coupled lasers in top view. Herein the first and second ridges 100, 120 of the laser structures follow a path similar to that of a directional coupler structure, each with a bend and with section lying close to the corresponding section of the other. At the ends of these sections of ridges 100, 120 Bragg gratings 30, 32 may be provided. At the far ends cleaved surfaces may be used. Instead of ridges 100, 120 with reflective surfaces at their ends ridges that loop around may be used.

The sections of the ridges that lie close to each other define a coupling region. For the front-to-front case of figure 1a,b the coupling is effect by partial transmission through reflective surfaces 17, directly injecting light into the neighboring laser. In the side-by-side case use is made of the decaying tail of field amplitude outside the waveguides formed by ridges 100, 120. These tails arise because light is not completely confined to the waveguide formed by the ridge 100, 120. The tail size may be defined for example by the lateral distance at which the field amplitude is less than one tenth of the field amplitude in the ridge 100, 120. Coupling arises because the ridges 100, 120 are in each other's tail, i.e. because their distance is less than the tail size.

In this embodiment, both lasers 10, 12 have mutually independent current contact electrodes 102, 122 and the laser ridges 100, 120 are isolated from each others so that no current leakage occurs between the two lasers 10, 12. It has been found that chaotic behavior is improved by keeping more than half of the ridges 100, 120 apart from each other (i.e. more than ten times as far apart as in the coupling region). Similarly, it has been found that the use of a Bragg grating at one end, nearest the coupling region makes it easier to ensure reliable operation.

A supply circuit similar to the one shown in figure 2 may be used. By using this circuit to set the injection currents asymmetrically, so that modal peaks of one laser overlap with flanking peaks of the other laser, a wide bandwidth may be realized.

Figure 4 shows an alternative embodiment in top view, with a band of InP 40, covered by an electrode 42. Cleaved surfaces 44 are provided at both ends of band 40. Band 40 has a width that supports a plurality of transverse modes. An electric current source (not shown) is provided, coupled to electrode 42, to provide injection current into band 40.

In normal laser structures the width of the ridge waveguide of the integrated laser is chosen so as to allow for only the fundamental transversal mode and the first and higher order transversal modes are cut-off. By designing the ridge wider than conventionally, the first order, or higher order transversal mode can be sustained in band 40. Because of the width the existence of at least two transverse modes is made possible. Each of these transversal modes defines a respective plurality of longitudinal standing wave patterns between reflective surfaces 44, the respective pluralities differing in the way in which the field depends on position in a direction transverse to the direction between reflective surfaces 44 and parallel to electrode 42.

In operation generation of chaotic light signals involves broadband self-injection between different transversal modes in a single integrated semiconductor laser. The separate transversal modes will feed from (slightly) different ensemble of carriers, allowing for 'two different lasers' in one laser. The location of the modal peaks of the different modes do not depend identically on the injection current, because the dynamic material properties at different positions across the width of band 40 affect the position of the modal peaks differently. The modal peaks may shift by different amounts, in response to changes in injection current. Thus, by selecting the injection current, different spectra with the configuration of figure 2b may be realized, for the fundamental transversal mode and a higher order transversal mode within a single laser structure, rather than for modes of different laser structures as in the case of the embodiments of figures 1a,b and 3.

The interaction between the modes also depends on injection current. Spatial hole burning may occur that is strong enough to sustain a 'gain grating' within the laser. Gain gratings are described in G. Kozyreff and Paul Mandel, "Antiphase dynamics and self-pulsing due to a low-frequency spatial population grating in a multimode laser", Phys. Rev. A 58, 4946 - 4955 (1998)). Such a gain grating will serve as a mixing mechanism for the optical fields of each longitudinal mode and the two transverse modes. The strength of the coupling will be proportional to the bias current, i.e. the more the current the stronger the field the deeper the holes and the larger the coupling.

An electric current source is used to provide injection current into band 40. This current source is set to supply a current value that is observed to maximize chaotic bandwidth. The current value may be set to supply current at a level that makes the modal peaks of the fundamental transversal mode overlap with flanking peaks of higher order transversal modes or vice versa. This leads to chaotic light generation. The required current depends on the specific construction of the device, but it can easily be selected by first varying the bias current and observing the bandwidth of the resulting generated chaotic light.

A specific choice of material may be used to improve operation. For the desired operation of the device, the material preferably has a strong tendency for spatial hole burning. This requires some charge localization. Quantum Dot (QD) based material will be excellently suited for such devices. Moreover, due to the large homogenous linewidth of the QD material the nonlinear dynamics will have a much larger bandwidth (∼ 20 nm ≈ 2.5 THz at 1555 nm), than with for instance Quantum Well or Bulk type material.

The dynamics in the alternative embodiment of figure 4 is not very well controllable as compared to the structure with a plurality of separate optically active ridges. The embodiment of figure 4 will either be in chaos or not and the regular nonlinear dynamics, which are normally a precursor to chaos, will be present in only a small parameter range.

This structure may also use two polarization modes of the laser instead of different transversal modes. Here the free spectral range of the laser has to be chosen carefully, if one desires a flat spectrum over the whole bandwidth. This is because light with different polarization will not interact with each other and the chaos generation mechanism in this case would be the interaction of the two polarization modes through the carrier depletion. This interaction bandwidth is restricted by the relaxation oscillations. Therefore to achieve broad band flat spectrum, the FSR is preferably approximately corresponds to twice the relaxation frequency or smaller, so as to allow the relaxation oscillations to fill the spectrum between two longitudinal modes of the laser. With this choice, the operation principle will be similar to the embodiment based on transverse modes. Again, the chaos is not well controllable, but will be very broadband.

Figure 5 shows a system using the chaotic light generators of the embodiments. The system may be used as a communication system for example. Herein an electronic information source 50 supplies an information signal. A chaotic light source/modulator 52 generates chaotic light and adds a modulation representing the information signal. A chaotic light source/modulator 52 comprises laser structures 10, 12 of figure 1 or 2 and their driving circuit (not explicitly shown), or a structure as shown in figure 4. The modulated light is transmitted to chaotic light receiver/demodulator 54, which retrieves the information signal and sends it to an electronic information processing device 56.

In order to demodulate the modulated light, an additional light signal may be transmitted between chaotic light source/modulator 52 and chaotic light receiver/demodulator 54, also dependent on the generated chaotic light, for use as a demodulation reference. In another embodiment receiver/demodulator 54 may comprise a counterpart of chaotic light source/modulator 52. Matching devices manufactured on the same substrate next to each other may be used for example.

A similar system may be used for light radar applications or for tomography. Herein chaotic light source/modulator 52 provides a probe signal, onto which information about the distance and/or optical transmission properties of material traversed by the probe signal is imposed. Chaotic light receiver/demodulator 54 demodulates this information. Basically, this corresponds to correlating the received signal with reference light obtained from source/modulator 52 or from a matched local reference source of chaotic light. The disclosed device is capable of producing extremely short pulses with a larger bandwidth than inevitable due to the short duration of the pulses. Self correlation of the pulses may suffice to detect information about the distance and/or optical transmission properties of material traversed by the probe signal.

Any one or combination of methods may be used to modulate and demodulate the light. In one embodiment, the amplitude and/or phase of a non-chaotically operating laser is modulated, and the resulting laser beam is injected into the ridge 100, 120 of at least one of first and second laser structures 10, 12 or into band 40. In this case the structures respond chaotically to the injected beam. In another embodiment a beam with modulated information may be added to light from the chaotic laser structure. In another embodiment a beam from the chaotic laser structure may be modulated by a controllable phase modulator.

Although devices with two coupled laser structures have been illustrated, it should be appreciated that a greater number of coupled laser structures may be used.

## Claims

1. A chaotic light generator device, comprising
- a first and second laser structure, integrated on a common substrate, each laser structure comprising a ridge of light amplifying material extending between at least partly reflective surfaces and an injection electrode for injecting electric current into the ridge of light amplifying material,
- a coupling between the first and second laser structure for exchanging light between the laser structures;
- a current feed circuit coupled to the electrodes and configured to apply mutually different current densities to the ridges of the first and second laser structures respectively.

2. A chaotic light generator device according to claim 1, wherein the current feed circuit is configured to supply a combination of currents to the electrodes at levels that make modal peaks of an individual spectrum of the first laser structure overlap flanking peaks of an individual spectrum of the second laser structure.

3. A chaotic light generator device according to claim 1 or 2, comprising a programmable current supply circuit, configured to set the currents to the electrodes of the laser structures individually according to programmable values.

4. A chaotic light generator device according to any one of the preceding claims, wherein the laser structures are positioned relative to each other each with a partly reflective one of the at least partly reflective surfaces facing a partly reflecting one of the at least partly reflective surfaces of the other laser structure.

5. A chaotic light generator device according to claim 4, wherein a distance between the facing surfaces of the first and second laser structure corresponds to between half a wavelength and ten wavelengths of light from the laser structures in material between the facing surfaces.

6. A chaotic light generator device according to any one of claims 1 to 3, wherein a portion of each of the laser structures is part of a directional coupler structure, said portion being a portion of a lateral side of the laser structure that extends between the at least partly reflecting surfaces of the laser structure.

7. A chaotic light generator device according to claim 6, wherein said portions each contain a Bragg grating at an end of the corresponding laser structure.

8. A chaotic light generator device according to claim 1, wherein the first and second laser structures have mutually different layout widths, so that the current densities of the laser structures will differ even when equal currents are supplied.

9. A method of manufacturing a chaotic light generator device, comprising providing a device according to claim 1 wherein the current densities are independently selectable, the method comprising measuring chaotic light output from the device for respective settings of the current, selecting a combination of currents that results in a maximum of bandwidth of the measured chaotic light and programming the device to supply the selected currents subsequently to the electrodes of the laser structures.

10. An optical signal processing system, comprising a chaotic light generator device according to any one of claims 1 to 7, and a demodulator configured to demodulate information from light obtained using the chaotic light generator device, by correlating the obtained light with reference light.

11. A chaotic light generator device, comprising
- a laser structure comprising a body of light amplifying material between at least partly reflective surfaces and an injection electrode for injecting electric current into the body of light amplifying material, said body having a width that supports a fundamental transversal mode and at least a higher order transversal mode;
- a current feed circuit coupled to the electrode and configured to apply a current at a level that makes modal peaks of an individual spectrum of a fundamental transversal mode overlap flanking peaks of a higher order transversal mode, or vice versa.

12. A method of generating a chaotic light signal, the method comprising
- providing a laser structure that supports a first and second set of laser modes, each set with a spectrum of regularly spaced mode peaks and flanking peaks adjacent the mode peaks;
- adjusting at least one injection current density of the laser structure to shift the mode peaks of the first set of laser modes to positions overlapping the flanking peaks of the second set of laser modes
- applying light of the first set of modes to non-linear light amplifying material that affects amplification of the second set of modes and vice versa.
